# EUROPEAN PATENT APPLICATION

(11) **EP 2 090 673 A1**
(43) Date of publication of application: **19.08.2009**
(21) Application number: 08100541.5
(22) Date of filing: 16.01.2008
(51) Int. Cl.: C23C 14/35, H01J 37/34, C03C 17/00

(54) **Sputter coating device**

(71) Applicant: Applied Materials, Inc., Santa Clara, CA 95054 (US)
(72) Inventor: Lopp, Andreas, 63579 Freigericht-Somborn (DE); Lindenberg, Ralph, 63654 Büdingen-Rinderbügen (DE)
(74) Representative: Lermer, Christoph

(57) **Abstract**

A sputter coating installation 1 comprises a vacuum chamber having an interior space 3'. The interior space 3' of the vacuum chamber is defined by chamber walls 3. According to the present invention, an array of target units 9 is arranged in line inside the vacuum coating chamber. Particularly, the target units 9 are arranged tiltable relative to the vacuum chamber and relative to a transport path t of a substrate 2. The target units 9 are cathode units or magnetron units and comprise a target and a housing. The housing is attached to the target and defines an interior space of the target unit. Within the interior space of the target units a number of components are arranged, e.g. a combination of a magnet yoke and a magnet system, a magnet yoke drive, a cooling system (arranged near the target), an electric current supply for supplying energy for the sputter process, etc. The combination of the magnet yoke and the magnet system is movable on a linear path to perform a reciprocating movement relative to the target during the operation of the target unit. Outside the housing a vacuum pressure pᵥ is generated vacuum pumps 5 arranged in a chamber wall 3c of the vacuum chamber behind the target units 9 for enabling the sputter coating process. In the interior space of the housing another pressure p may prevail, particularly a considerably higher pressure p. For example, the pressure p in the interior space of the housing may be an atmospheric pressure. Therefore, the housing provides a vacuum sealing of the interior space of the housing relative to the outside of the housing.

## Description

### TECHNICAL FIELD

The present invention concerns a sputter coating device, comprising at least one coating chamber, and at least a first target unit arranged inside said coating chamber, wherein said target unit comprises at least one substantially planar sputter target.

### PRIOR ART

Sputtering is a well-known technology for depositing films of various materials on a substrate. In a static sputter coating process the substrate is positioned opposite a target while being coated. In a dynamic sputter coating process the substrate is transported continuously past a plurality of sputter targets during the coating process.

In conventional vacuum coating installations rotatable magnetrons and planar magnetrons are used. Rotatable magnetrons comprise a rotatable cylindrical target and a magnet system positioned inside the target. Planar magnetrons have a substantially planar target surface and a magnet system moveably positioned behind the target. A plurality of magnetrons may be arranged in a coating chamber in line.

Rotatable magnetrons are used in order to prevent a re-deposition of particles on the surface of the target. Vacuum pumps of a vacuum system may be positioned on the back side of the magnetron, i.e. on the side opposite the position of the substrate. Thus, the length of an in-line system of rotatable cathodes may be reduced. Furthermore, due to a short distance between the targets the uniformity of a film deposited on the substrate may be improved.

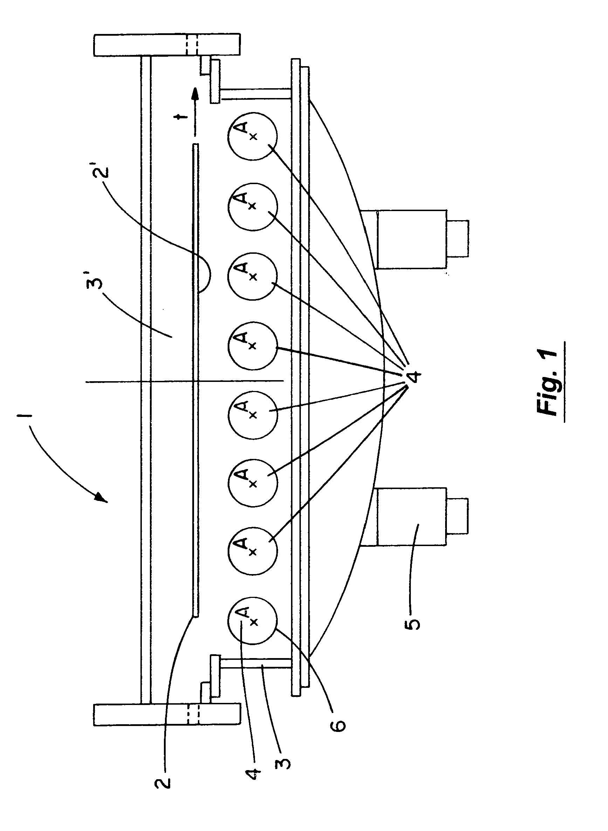

Fig. 1 illustrates a coating system 1 for depositing a layer or a layer system on the surface of a substrate 2 in a dynamic coating process. The substrate 2 is transported through a coating chamber 3 past a plurality of rotatable cathodes 4 in a direction indicated by an arrow t. The cathodes 4 having cylindrical targets 6 are arranged in line with a short distance between the cylindrical targets 6. During the coating process each of the rotatable targets 6 is rotated around a respective central axis A, while the magnet systems are stationary. On the back side of the cathodes 4, i.e. in the wall section of the coating chamber 3 facing the surface 2' of the substrate 2 vacuum pumps 5 are provided to evacuate the interior space 3' of the vacuum chamber 3.

The system 1 allows the deposition of a uniform coating layer or layer system on the substrate 2. However, cylindrical targets 6 are not available for all materials. Furthermore, cylindrical targets 6 for rotatable cathodes 4 are quite expensive.

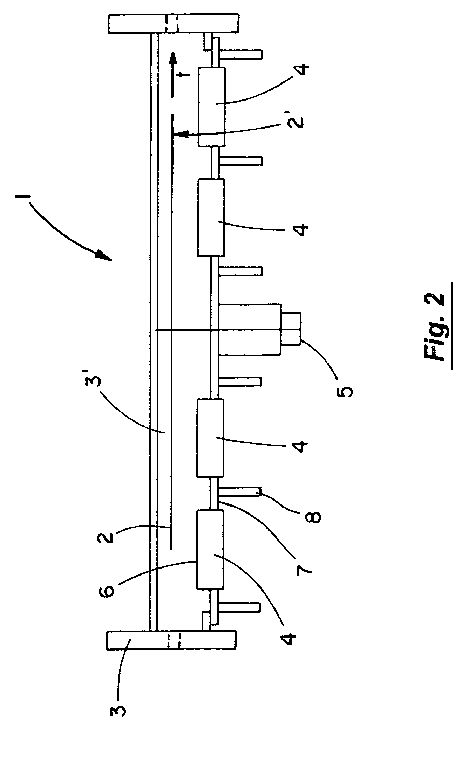

In Fig. 2 a coating system 1 having an in-line arrangement of planar magnetrons 4 is illustrated. In order to prevent the re-deposition of particles on the surface of the planar targets 6, the planar magnetrons 4 are equipped with a moveable magnet system (not illustrated) for generating a non-stationary racetrack above the sputter surface of the target 6. The targets 6 and the magnet systems are arranged in a wall section 7 of the coating chamber 3. The magnets of the magnet systems are driven by a drive system for providing a relative movement of the magnets relative to the target 6. A pump 5 is also arranged in line with the magnetrons 4, i.e. between two adjacent magnetrons 4, in the wall section 7. The wall section 7 is equipped with reinforcing ribs 8 to strengthen the wall section 7 of the chamber wall 3. During the coating process a substrate 2 is transported through the interior 3' of a coating chamber 3 in a transport direction t. While the substrate 2 passes the cathodes 4 material is sputtered from a surface of the targets 6 and the sputtered material is deposited on the surface 2' of the substrate 2.

The coating system 1 shown in Fig. 2 has four magnetrons 4 and a pump 5 arranged in line. This implicates quite a long extension of the coating system 1 in the transport direction t of the substrate 2.

### OBJECT OF THE INVENTION

It is an object of the present invention to provide a sputter coating device for the use of planar targets, wherein the sputter coating device has a coating quality and efficiency comparable with the coating quality provided by rotatable magnetrons.

### TECHNICAL SOLUTION

This object is solved by a coating device according to claim 1. The dependent claims refer to features of particular embodiments of the invention.

The inventive sputter coating device comprises: at least one coating chamber; and at least a first target unit arranged inside said coating chamber, wherein said target unit comprises at least one substantially planar sputter target. According to the invention the target unit comprises a housing defining an interior space of the target unit.

The target unit may be cathode unit and/or a magnetron having a planar target surface. The housing encloses an interior space of the target unit. The interior space defined by the housing is separated from the inside of the vacuum chamber. The interior space may be enclosed by the housing and/or the target. In other words, the housing may be sealed or have an opening covered by the target. However, because the pressure in the interior space is usually higher than the pressure outside the housing, i.e. in the vacuum chamber, the target has to be secured to the housing.

An advantage of the present construction is that the planar magnetron may be installed in a coating chamber instead of a rotatable magnetron without having to carry out constructive modifications of the chamber. According to the invention, it is possible to replace rotatable magnetrons with planar magnetrons in existing coating devices in order to save acquisition costs for the target material. In a preferred embodiment the target unit is removable from the inside of the coating chamber and may thus be exchanged easily.

The vacuum pumps may be arranged in a section of a wall of the coating chamber behind the sputter surface of the planar target. In other words, the pumps may be arranged in a wall of the coating chamber which is arranged face-to-face with the surface of the substrate to be coated.

In a preferred embodiment of the invention the interior space of the target unit is vacuum sealed relative to the inside of the coating chamber.

The interior space of the target unit is hermitically sealed relative to the inside of the coating chamber. In the interior space there may be a higher pressure, e.g. an atmospheric pressure, than outside the housing where a vacuum pressure prevails for generating an atmosphere suitable for carrying out a sputter process.

In a preferred embodiment of the invention a cooling system and/or an electric current supply system and/or a cooling medium supply is arranged within the interior space of the target unit. Due to the fact that the atmosphere and the pressure in the interior of the target unit may differ from the pressure in the coating chamber they may be set independently from other process parameters, e.g. the pressure in the coating chamber.

Particularly, the target unit is arranged rotatable and/or tiltable around an axis of rotation relative to the vacuum chamber. The rotation allows for an arbitrary alignment of the surface of the target with respect to the coating chamber, the substrate, etc. For example, the target unit may be tilted such that the sputter surface of the target is directed away from the substrate or the transport path of the substrate. Then the sputter surface of the target may face a pre-sputter plate to carry out pre-sputtering of the target before the actual coating process. Furthermore, the target unit may be tilted to be directed at the surface of the substrate in an angle suitable for the coating process, e.g. in an angle between 0° and +/- 45°, during the sputter coating process, wherein the angle is a parameter of the coating process. During the coating process the substrate faces the sputter surface of the target at a predetermined angle. Particularly, the target surface is arranged in an angle of 0° relative to the sputter surface of the target, i.e. it is arranged in a sputter position directly facing the target.

It is also possible to sway or rotate the target unit around a longitudinal axis of rotation during the sputter coating process in a reciprocating manner during the coating process.

In a preferred embodiment of the invention the coating device comprises a transport system for transporting a substrate into and out of the coating chamber in a position facing the target and/or for transporting the substrate through the coating chamber past the target. The substrate may be aligned and/or stopped before carrying out the coating process (static coating process) or it may be moved passing the target unit while being coated (dynamic coating process). The substrate may be transported into the coating chamber and/or through the coating chamber aligned in a substantially vertical position, in a substantially horizontal position or in an inclined position.

It is preferred that the axis of rotation of the target unit is arranged substantially parallel to the surface of the substrate in a deposition position and/or perpendicular to a direction of movement of the substrate while passing through the inside of the coating chamber.

In a particular embodiment of the invention the target unit comprises a magnet assembly for generating a magnetic field above the sputter surface of the target. The target unit in this embodiment of the invention is a magnetron unit. The magnet assembly usually comprises at least one, particularly a plurality of magnets. The magnet assembly generates a plasma confinement zone above the sputter surface of the target which is usually called a racetrack. The magnet assembly may be mounted on a yoke.

In a preferred embodiment the magnet assembly is arranged in the interior space of the target unit.

Particularly, the magnet assembly is arranged movable relative to the target. For example, it may be movable on a linear path, e.g. for carrying out a reciprocating movement. Due to the movement of the magnet assembly a re-deposition of particles on the sputter surface is prevented. Furthermore, a uniform erosion profile of the target (i.e. good target utilization) and thus a uniform coating on the surface of the substrate may be obtained. The invention especially relates to magnetron sputtering using a movable magnetic system in a vacuum coating installation. The quality and efficiency of the coating process is comparable or better than the quality and efficiency of a coating process with rotatable magnetrons.

In a preferred embodiment the coating device comprises a drive for providing a rotating movement, and a transformer mechanism for transforming said rotating movement into a substantially linear movement. The substantially linear movement may be a reciprocal movement scanning the complete sputter surface of the target. The transformer mechanism may be a gear box and/or a drive unit originally provided for the rotation of a cylindrical rotatable target which, in the present invention, is used for driving the movable magnet assembly of the planar magnetron unit. The transformer mechanism is particularly arranged in the interior space of the target unit. Thus, the planar target unit may be installed easily in a coating chamber instead of a rotatable magnetron. The rotating movement of the drive which usually rotates the cylindrical target of a rotatable magnetron is connected to the gear box of the target unit to provide a linear movement of the magnet assembly of the target unit. For example, the rotation of a shaft may be transmitted to the transformer mechanism by connecting the shaft with a corresponding connector of the target unit. The connector of the target unit may comprise a rotary vacuum feedthrough. Therefore, there is no need to implement a new drive mechanism in an existing coating device.

The drive may be arranged at least partially outside the coating chamber. The drive shaft may extend through a rotary vacuum feedthrough provided in a wall of the coating chamber.

In a particular embodiment of the invention the coating device comprises a bracket to support the target unit in the vacuum coating chamber. The bracket connects the target unit with at least a wall of the vacuum coating chamber. The bracket may comprise a tilting mechanism to provide a tilt of the target unit and the target. The bracket may also comprise a rotating mechanism for transferring a rotation of a shaft or spindle to move a magnet assembly to scan the target surface on a substantially linear (reciprocating) path, wherein the magnet assembly is accommodated in the interior space of the target unit.

In a preferred embodiment of the invention the target unit is arranged in a distance from the wall of the coating chamber that faces the coating surface of the substrate. In other words, behind the target units there is some free space which enables the target unit to be rotated/tilted relative to the back wall of the coating chamber. For that reason the axis of rotation may be arranged substantially parallel to the back wall of the coating chamber. Usually, the target unit and/or the bracket are not connected or in contact with the back wall of the coating chamber.

It is preferred that at least one pump for generating a vacuum within the coating chamber is arranged in a wall of the coating chamber behind the target unit, i.e. on the other side of the target unit than the substrate. I.e. the at least one pump is provided in a wall facing the surface of the substrate to be coated. The feature facilitates an arrangement of a large number of target units arranged in-line within a short distance along the transport path of the substrate thus improving the quality of the coating while reducing the longitudinal extension of the coating chamber.

It is preferred that the coating chamber comprises a modular configuration comprising at least a support for supporting the first target unit, and a cover constituting a portion of a wall of the coating chamber. This construction is disclosed in the applicant's publication US 2006/0226004 Al, the content of which is enclosed herein by reference. The construction may be regarded as a sandwich constructing having a chamber section for transporting the substrate therethrough, a cover that provides an outer wall section of the coating chamber and a support sandwiched between the chamber section and the cover. The support carries the cathodes (in the present invention it carries the target units), and the cover particularly carries at least one pump and/or the pump system.

In another preferred embodiment of the invention the coating device comprises a second target unit or a plurality of second target units arranged inside the coating chamber. The plurality of first and second target unit(s) may be arranged adjacent to each other establishing an arrangement of sputter sources in the coating chamber.

In a preferred embodiment of the invention the first target unit and the second target unit or the second target units are arranged in-line beside the transport path of the substrate to be coated. The target units may be arranged on a linear path, but may also be arranged along a curved path or along any other geometrical path. The longitudinal axes (axes of rotation) of the target units are substantially arranged parallel to each other. The second target unit or second target units may have the same construction as the first target unit. All characteristics and features described in connection with the first target unit may be attributable to the second target unit or second target units. However, the target material of the targets of the first target unit and particular second target units may be the same or different, depending on the required sequence of coating layers on the substrate.

It is particularly preferred that the first target unit and/or the second target unit or second target units are supported by the at least one support.

### BRIEF DESCRIPTION OF THE DRAWINGS

Further features and advantages of the invention will be apparent from the following description of preferred embodiments and the attached drawings. The drawings show:
- Fig. 1: a coating device having rotatable magnetrons according to the prior art;
- Fig. 2: a coating device having planar magnetrons according to the prior art;
- Fig. 3: a sectional view of a target unit according to the present invention;
- Fig. 4: a sectional view of an array of target units according to the present invention; and
- Fig. 5: a sectional view of a coating device according to the present invention.

### DESCRIPTION OF PREFERRED EMBODIMENTS

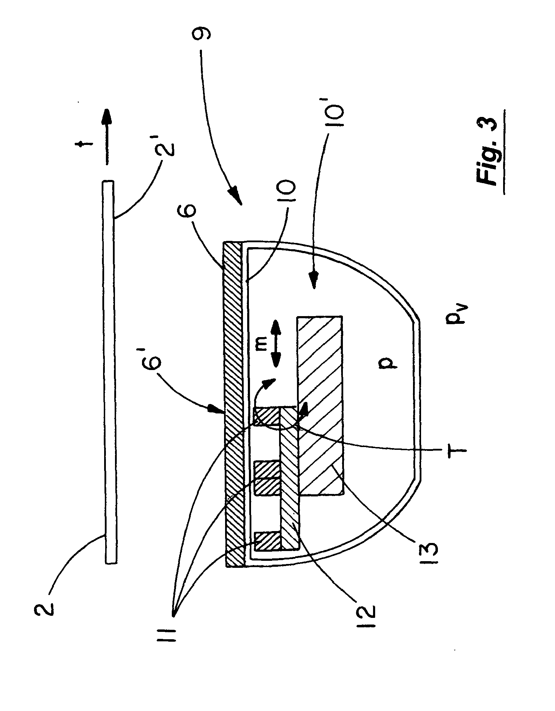

Fig. 3 depicts a target unit 9 according to the present invention. The target unit 9 is a cathode unit or magnetron unit and comprises a target 6 and a housing 10. The housing 10 is attached to the target 6 and defines an interior space 10' of the target unit 9.

Within the interior space 10' of the target unit 9 a number of components are arranged. On the side of the target 6 opposite the sputter surface 6' a movable magnet system 11 is arranged and fixed to a movable magnet yoke 12. The combination of the magnet yoke 12 and the magnet system 11 is movable on a linear path indicated by an arrow m to perform a reciprocating movement relative to the target 6 during the operation of the target unit 9. The combination of the magnet yoke 12 and the magnet system 11 is driven by a magnet yoke drive 13. The magnet yoke drive 13 may be a gear box for transforming a rotatable movement, e.g. of a shaft, coupled into the magnet yoke drive into a linear movement of the combination of the magnet yoke 12 and the magnet system 11. Alternatively, the magnet yoke drive 13 may comprise an actuator or a motor to generate the movement of the combination of the magnet yoke 12 and the magnet system 11.

Fig. 3 illustrates the target unit 9 arranged in a sputter position relative to a glass substrate 2. The glass substrate 2 passes the target unit 9 in a transport direction indicated by an arrow t during the sputter operation to provide for a dynamic deposition process. The sputter surface 6' of the target 6 faces the surface 2' of the substrate 2 directly.

However, the target unit 9 (and the target 6) are arranged tiltable within a coating chamber as indicated by an arrow T and thus may be tilted relative to the transport path t of the substrate 2. The angle of tilt between the surface 6' of the target 6 and the surface 2' of the substrate 2 may be set as a parameter for a sputtering process. Furthermore, the target unit 9 may be tilted for performing a pre-sputtering process.

The housing 10 encloses a number of components, e.g. the magnet yoke drive 13 and the combination of the magnet yoke 12 and the magnet system 11 as shown, but also a cooling system (arranged near the target 6), an electric current supply for supplying energy for the sputter process, etc. Outside the housing 10 a vacuum pressure pᵥ is generated for enabling the sputter coating process. In the interior space 10' of the housing 10 another pressure p may prevail, particularly a considerably higher pressure p. For example, the pressure p in the interior space 10' of the housing 10 may be an atmospheric pressure. Therefore, the housing 10 provides a vacuum sealing of the interior space 10' of the housing 10 relative to the outside of the housing 10.

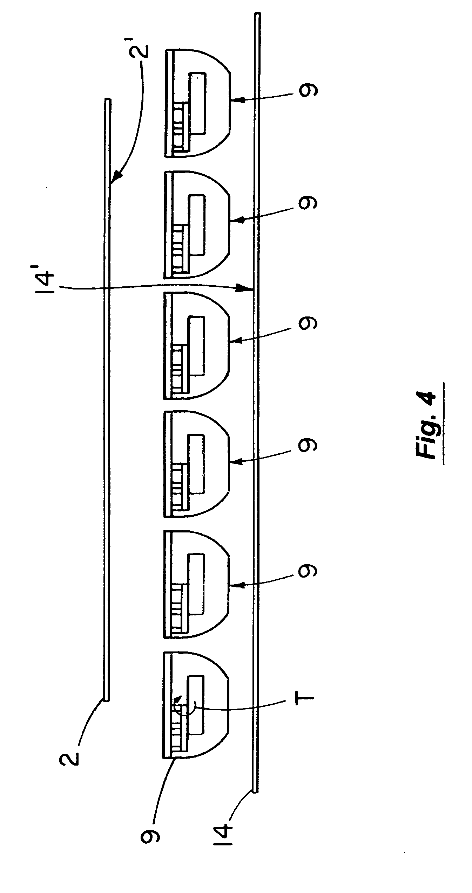

Fig. 4 illustrates an array of target units 9 used for a static deposition process to deposit a layer or a layer stack of coating material(s) on a glass substrate 2. Each of the target units 9 of the array of target units 9 may be tilted as exemplarily indicated in one of the target units 9 by an arrow T. Of course, the other target units of the array are also tiltable. The target units 9 are substantially configured as described above.

Furthermore, the arrangement comprises a pre-sputter plate 14 arranged in a coating chamber (not shown) on a side opposite the coating surface 2' of the glass substrate 2 relative to the target units 9. The target units 9 may be tilted to face the surface 14' of the pre-sputter plate 14 during the pre-sputter process, and tilted to face the coating surface 2' of the substrate 2 during the sputter deposition process.

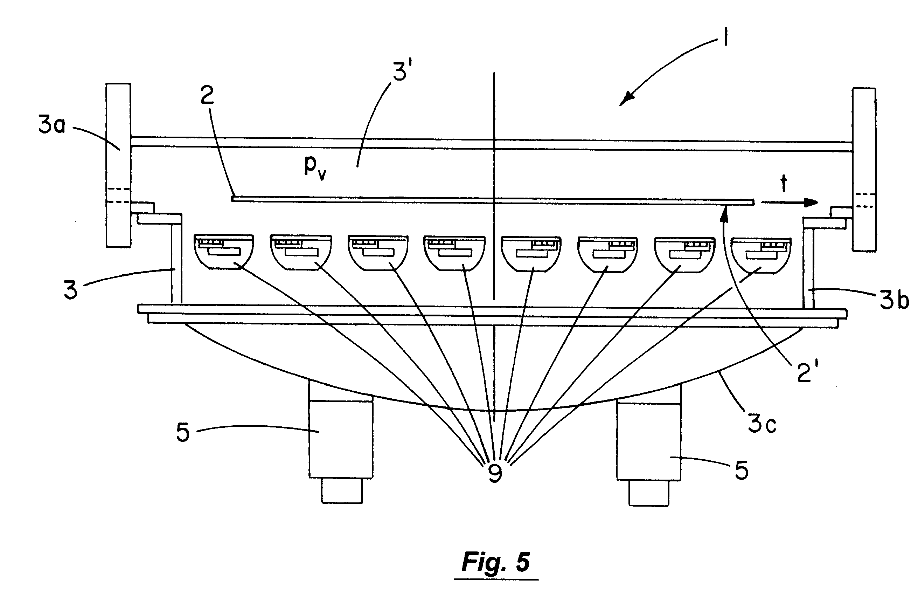

Fig. 5 depicts a sputter coating installation 1 according to the present invention. The sputter coating installation 1 comprises a vacuum chamber having an interior space 3'. The interior space 3' of the vacuum chamber is defined by chamber walls 3.

In a static coating process a glass substrate 2 is positioned in the interior space 3' of the vacuum chamber, and in a dynamic coating process a substrate 2 is transported in a direction t through the interior 3' of the vacuum chamber.

According to the present invention, an array of target units 9 is arranged in line inside the vacuum coating chamber. Particularly, they are arranged tiltable relative to the housing 3 of the vacuum chamber and relative to the transport path t of the substrate 2. The target units 9 are substantially configured as described above.

Furthermore, the sputter coating device 1 comprises a vacuum system having a number of vacuum pumps 5. The vacuum pumps 5 are provided in a wall 3' of the vacuum chamber, wherein the wall portion 3c carrying the pumps 5 is arranged behind the target units 9, i.e. in a wall portion opposing the coating surface 2' of the substrate 2.

In the particular embodiment of Fig. 5 the coating installation 1 and the vacuum coating chamber, respectively, have a modular configuration comprising a chamber portion 3a, a support portion 3b and a cover portion 3c. The chamber portion 3a defines an interior space through which the substrate is transported and in which the substrate 2 is positioned, respectively, during the coating process. The support portion 3b defines a space for accommodating the target units 9 and attachment means for attaching and carrying the target units 9. The cover portion 3c carries the pumps 5. The portions 3a, 3b and 3c are detachable from each other when the interior space 3' of the vacuum chamber 3 is vented. Therefore, handling and exchange of the target units 9 is easy.

The pumps 5 generate a vacuum pressure pᵥ suitable for a sputter process in the interior space 3' of the vacuum chamber. In the interior space 9' of the target units 9, on the other hand, there may be another pressure p, e.g. an atmospheric pressure p.

The target units 9 having planar targets 6 may be installed in the coating device 1 instead of rotatable magnetrons. The drive system that usually drives the rotatable cathodes is used to move the magnet system of the target units 9 to provide a magnetron having movable magnets. Due to the fact that the planar target unit 9 has a movable magnetron for scanning the surface 6' of the target 6 a uniform target utilization and thus a good quality of the coating layer deposited on the substrate 2 may be provided which is comparable with the quality of a coating layer deposited on a substrate using a rotatable magnetron.

## Claims

1. A sputter coating device (1) comprising: at least one coating chamber (3); and at least a first target unit (9) arranged inside said coating chamber (3), wherein said target unit (9) comprises at least one substantially planar sputter target (6),
**characterized in that**
said target unit (9) comprises a housing (10) defining an interior space (10') of said target unit (9).

2. The sputter coating device (1) according to claim 1, **characterized in that**
said interior space (10') of said target unit (9) is vacuum sealed relative to the inside of the coating chamber (3).

3. The sputter coating device (1) according to claim 1 or 2, **characterized in that**
said sputter coating device (1) comprises a cooling system and/or an electric current supply system and/or a cooling medium supply arranged within the interior space (10') of the target unit (9).

4. The sputter coating device (1) according to any of the previous claims, **characterized in that**
said target unit (9) is arranged rotatable and/or tiltable around an axis of rotation (A) relative to the vacuum chamber (3).

5. The sputter coating device (1) according to any of the previous claims, **characterized in that**
said coating device (1) comprises a transport system for transporting a substrate (2) into and out of the coating chamber (3) in a position facing the target (6) and/or for transporting a substrate (2) through the coating chamber (3) past the target (6).

6. The sputter coating device (1) according to any of the previous claims, **characterized in that**
said target unit (9) comprises a magnet assembly (11) for generating a magnetic field above the sputter surface of the target (6).

7. The sputter coating device (1) according to claim 6, **characterized in that**
said magnet assembly (11 is arranged in said interior space (10') of said target unit (9).

8. The sputter coating device (1) according to any of the previous claims 6 or 7,
**characterized in that**
said magnet assembly (11) is arranged movable relative to said target (6).

9. The sputter coating device (1) according to any of the previous claims, **characterized in that**
said coating device (1) comprises a drive for providing a rotating movement, and a transformer mechanism (13) for transforming said rotating movement into a substantially linear movement.

10. The sputter coating device (1) according to any of the previous claims, **characterized in that**
said coating device (1) comprises a bracket to support said target unit (9) in said vacuum coating chamber (3).

11. The sputter coating device (1) according to any of the previous claims, **characterized in that**
said target unit (9) is arranged in a distance from the wall (3c) of the coating chamber (3) that faces the coating surface of the substrate (2).

12. The sputter coating device (1) according to any of the previous claims, **characterized in that**
said coating device (1) comprises at least a pump (5) for generating a vacuum within the coating chamber (3), and said pump (5) is arranged in a wall of the coating chamber behind the target unit (9).

13. The sputter coating device (1) according to any of the previous claims, **characterized in that**
said coating chamber (3) comprises a modular configuration comprising at least a support (3b) for supporting said first target unit (9), and a cover (3c) constituting a portion of a wall of said coating chamber (3).

14. The sputter coating device (1) according to any of the previous claims, **characterized in that**
said coating device (1) comprises a second target unit (9) or a plurality of second target units (9) arranged inside said coating chamber (3).

15. The sputter coating device (1) according to any of the previous claims, **characterized in that**
said first target unit (9) and said second target unit or the second target units (9) are arranged in-line beside a transport path of the substrate (2) to be coated.

16. The sputter coating device (1) according to any of the previous claims 13 to 16,
**characterized in that**
said first target unit (9) and/or said second target unit and said second target units (9), respectively, are supported by said at least one support (3b).

## Amended claims

### Amended claims in accordance with Rule 137(2) EPC.

**1.** A sputter coating device (1) comprising:
at least one coating chamber (3) comprising a wall; and
at least a first target unit (9) arranged inside said coating chamber (3), wherein said target unit (9) comprises at least one substantially planar sputter target (6), and wherein
said target unit (9) comprises a housing (10) defining an interior space (10') of said target unit (9),
**characterized in that**
said target unit (9) is arranged in a distance from the wall (3c) of the coating chamber (3) that faces the coating surface of the substrate (2) such that behind the housing (10) there is some free space between the housing (10) and the wall of the coating chamber (3).
